# EUROPEAN PATENT SPECIFICATION

(11) **EP 0 551 529 B1**
(45) Date of publication and mention of the grant of the patent: **12.06.1996**
(21) Application number: 91121799.0
(22) Date of filing: 19.12.1991
(51) Int. Cl.: H05K 3/22

(54) **Method for replacing chips**
Ersetzungsverfahren für Chips
Méthode de remplacement de puces

(43) Date of publication of application: 21.07.1993
(73) Proprietor: International Business Machines Corporation, Armonk, N.Y. 10504 (US)
(72) Inventor: Fink, Peter, Dipl.-Ing., W-7262 Althengstett (DE); Horbach, Günter-Heinz, Dipl.-Ing., W-7268 Gechingen (DE)
(74) Representative: Rach, Werner, Dr.

(56) References cited:
- EP-A- 0 083 265
- IBM TECHNICAL DISCLOSURE BULLETIN vol. 31, no. 11, April 1989, page 214; 'CHIP REMOVAL METHOD'

## Description

The invention refers to a method for replacing chips directly attached on boards (also called chip-on-board packaging). Further described is an adapted board and replacement module which both can be used to perform the method and the resulting board.

The best packaging for the future may be as few levels of packaging as possible for a given application. This might be realized directly mounting the chip on the board. This so-called direct chip attach (DCA) or chip-on-board (COB) packaging can provide the smallest and cheapest package among various packaging technologies.

The devices directly attached on the boards are usually electrically connected by wire bond or tape automated bonding (TAB) technology which will further need protection from process chemicals, dust and humidity. Thus, a resin encapsulant is placed over the chip and the wiring connecting the chip pads with the board.

In case of a malfunction of such an encapsulated chip the removal and replacement of the chip is not possible without damaging the circuitry and the organic carrier (board). Subsequently replacing the chip with a new one by using the normal direct chip attach soldering process is also not possible. Thus, a fully assembled board has to be scrapped.

In the IBM Technical Disclosure Bulletin, Vol. 29, No. 3, August 1986, p. 1433 a reworkable chip-on-board package is disclosed, in which back bonded chips in a recess in case of malfunction are substituted by a second back bonded chip on top of the defect chip. Before the replacement chip is fixed on top of first chip, the wire bond pads are removed. This method requires a recess for the chip and allows only one rework cycle per chip.

IBM Technical Disclosure Bulletin, Vol. 31, No. 3, August 1988, p. 39 shows the test and repair of direct chip attach modules which are C4-bonded (controlled collapsed chip connection), in which a thermode is placed on the back side of the substrate on which the chip is directly attached. The thermode is used to reflow the solder and allowing the chip removal. This method only can be used with single layer substrates and nonsealed chips.

The present invention as claimed therefore is intended to remedy these drawbacks by providing a new replacement technique for directly attached chips.

According to the invention as defined in claim 1 a new method is described in which at first the electronic component and the surrounding fan-out wiring area on the board is mechanically removed. The electronic component, which usually is a chip with a plurality of input and output (I/O) terminals arranged close together, needs a fan-out wiring which matches the distances usually used between the wiring lines on the board to the small distances between the I/O terminals of the chip. Thus, the fan-out wiring area is the region around the chip in which the chip I/O terminal distances are matched to board wiring distances. In this area at least the wiring and the chip are removed to provide a usually rectangular region on the board without wiring and chip. With the removal at least a thin layer of the board will also be removed; but it is also possible to provide a recess in the board. In a multilayer printed circuit board this recess should have a depth which does not influence the next wiring layer. The mechanical removal can be accomplished by appropriate methods well known to a person skilled in the art which are exact enough to provide a defined region with a defined depth. A preferred mechanical removal technique is micro milling.

Subsequent to the removal a card module is placed and fixed on the board at the location of said removed electronic component and said fan-out wiring area such that the card module wiring matches with the board wiring. The card module, which has the same wiring layout like the wiring on the board before removal and on which a chip is also directly attached, is placed in the wiring free region on the board. Preferably, the card module has the same size like the wiring free region so that the card module can be inserted in the recess to provide as short connections as possible between the card module and the wiring on the board. It is also possible to use a card module having contact means on the bottom side and which are a little amount larger than the free region in order to contact the wiring on the board by solder balls. The fixing of the card module is accomplished by common bonding agents.

After placing and fixing the card module the wiring of said board is electrically connected with the wiring of said card module. This can be accomplished by wire bonding or tape automated bonding or other appropriate solder techniques.

For performing the method of this invention an adapted printed circuit board as defined in claim 6 is used with at least one wiring layer on top of the board which comprises connection lines connecting the contact pads of different electronic components and at least one electronic component directly attached to the board. The board can be a multilayer board or a board only having wiring on the top and/or bottom surface. The board comprises contact means which are arranged adjacent the fan-out wiring area on the wiring lines leading to the contact pads of said directly attached component in a predetermined distance to said component. The contact means serve for the electrical connection of the wiring lines on the board to the wiring lines on the card module. The electrical connection can be performed by wire bonding, tape automated bonding or other appropriate solder bonding. Thus, dependent on the connection technique the contact means may comprise lands or blind holes or what ever is appropriate dependent from the preferred connecting principle. Solder bonding might be used by providing an adapted card module with soldered contact means at the side of the chip carrying carrier which is inserted in a recess so that the blind hole electrically contacts the contact means on the card module. It is an important feature that these contact means are arranged on the wiring of the board adjacent the fan-out wiring area to allow a replacement of a directly attached chip and its corresponding fan-out wiring area by a card module with the same chip and fan-out wiring. On the other hand the contact means should be as close as possible to the fan-out wiring area in order to have short connecting wires to the card module and to have a small free region. In a very simple embodiment of the board the design of the board comprises around the places where chips are directly attached lands on the wiring such that the chip and the respective fan-out wiring can be removed and completely disconnected.

For replacing a directly attached chip on the board a card module is necessary (see e.g. EP-A-0 083 265) which comprises a thin carrier card with an electronic component directly attached thereto and connected to a fan-out wiring which ends at the edges of said carrier and contact means for electrically connecting said wiring to the wiring of said board. The carrier can be made of the usual card material (organic or anorganic material) and the thickness as low as possible to provide a card module which can be handled and which requires a short connection wiring to the board. The chip on the card is also directly attached and connected as usual to a fan-out wiring on the carrier card. The arrangement of the chip and the fan-out correspond with the respective fan-out and chip on the printed circuit board. The fan-out wiring should terminate at the edges of the carrier card for allowing short connections to the board. Thus, the contact means on the card module are preferably arranged at the end of the fan-out wiring and comprise lands on the top or vias on the bottom side of the card module, latter for providing an electrical contact to the board wiring via solder balls. For special applications contact areas preferably covered with solder may extend over the sides of the card module for electrically contacting respective areas in a recess on the board. The chip on the card module can be covered by an encapsulant. The card module is functionally identical to the direct chip attach site on the board with additional contact means for electrical connections. The size of the card module depends mainly on the size of the chip, the number of connections and the geometry of used groundrules.

Further the invention refers to a printed circuit board with at least one wiring layer on top of the board which comprises connection lines for connecting the different electronic components. The board comprises contact means in a predetermined distance to said component and adjacent to the fan-out wiring area which are arranged on the wiring lines leading to the contact pads of at least one of the components. Further, the board comprises a thin card module carrying directly attached one component and the corresponding fan-out wiring area and card contact means. The card module is directly fixed to the board such, that the fan-out matches with the wiring on the board. Connecting means connect the board contact means with the card contact means. This board can be the result after replacing a previous damaged chip by a new replacement chip or a general concept for fixing sensitive chips on a board. Preferably, the card module can be arranged in a recess and the contact means on the board are contact lands which are wire bonded with the contact means on the carrier of the card module. The card module can also be fixed and electrically connected as already discussed above by solder balls or TAB technology.

The present invention has the advantage to provide a complete solution to the direct chip attach replacement problem which allows cost saving because the board having one defect directly attached chip will not be scrap anymore but can easily be reworked. This can be prepared by a simple change of the layout of the board. The card module can be prepared and tested inclusive burn-in stress test prior usage (which is not possible on the original DCA chip). The removal can be accomplished by well known and exact mechanical methods.

For a better understanding of the present invention, together with further objects and advantages, preferred embodiments of the invention are described in the following with reference to the accompanying drawings, in which
- Fig. 1: depicts a part of printed circuit board with a directly attached chip and the corresponding fan-out wiring in a perspective view;
- Fig. 2: schematically shows the top view of the wiring around a directly attached chip;
- Fig. 3: shows the board of Fig. 1 with a removed chip and fan-out wiring and a recess in the board at the former location of chip and fan-out wiring;
- Fig. 4: discloses the board of Fig. 3 and a card module to be placed in the recess; and
- Fig. 5: depicts in a perspective view a printed circuit board with a card module having a fully tested chip connected to the wiring on the card module placed in the recess of Fig. 3.

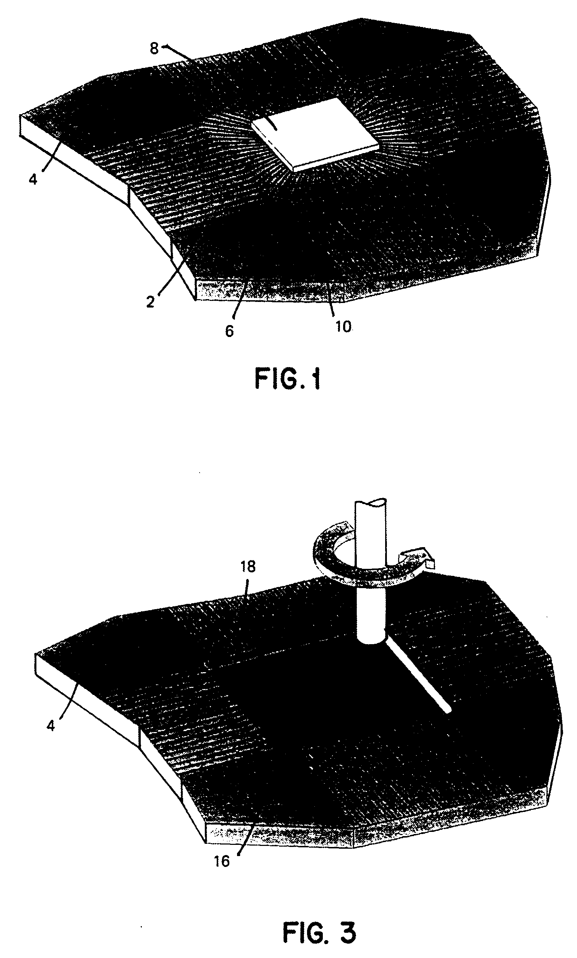

As shown in Fig. 1 the wiring 2 on the board 4 (from which only a part is depicted) is provided with lands 6 in a predetermined distance to the chip 8. The lands 6 are arranged adjacent the fan-out wiring area 10 in which the small distances of the chip pads 12 are adapted to the wider distances necessary for the board wiring. In Fig. 1 only the wiring on the top of the board is shown. Usually the board will be a multilayer printed circuit board. The chip can be connected by C4 technology with the face down to the board or by TAB or wire bond technology. As mentioned above also other suitable bonding technics can be used. For the purpose of clarity the encapsulant usually protecting the chip is not shown.

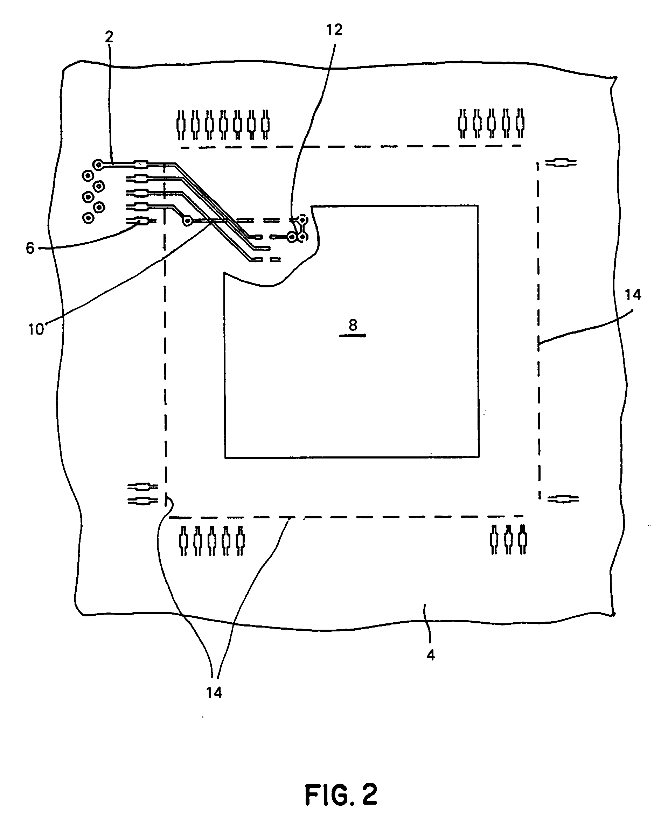

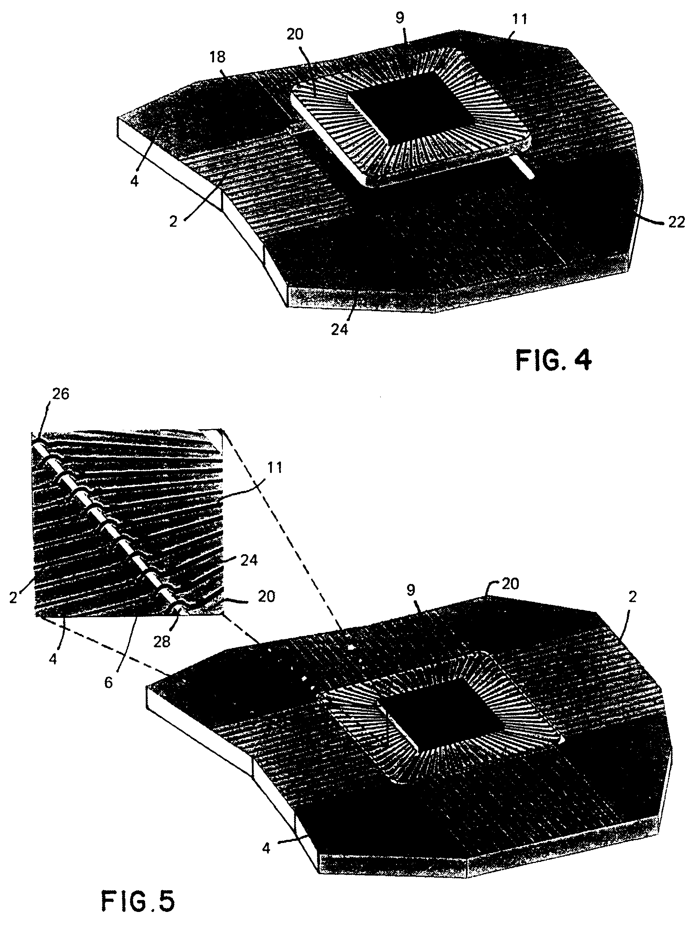

Fig. 2 shows the top view of a part of the wiring design on the top of the printed circuit board 4. In this embodiment the chip is connected to the board by a controlled collapsed chip connection (C4). For depiction purposes a part of the chip 8 is broken away. Around the fan-out wiring area 10 lands 6 on the wiring 2 are indicated. Between the fan-out wiring area 10 and the lands 6 a cutting line 14 is shown. Along this cutting line the fan-out wiring 10 and the chip 8 can be mechanically removed by micro milling as shown in Fig. 3. The design of the fan-out wiring and the lands must assure that a complete disconnection of the fan-out wiring of chip which shall be replaced is accomplished. The geometry of the lands 6 has to correspond to the appropriate design specifications, e.g. 400 µm wiring, land size 200 µm x 300 µm, 200 µm spacing.

In the preferred embodiment according to Fig. 3 a defect directly attached chip and the fan-out wiring area 10 are removed by micro milling thereby providing a recess 16 in the board 4. In general the recess has the size of the fan-out wiring area 10. The border 18 of the recess 16 corresponds with the cutting line 14 of Fig. 2. The depth of the recess 16 is such that the wiring in the board leading to the removed chip is effectively broken but the wiring planes located in a multilayer board below the recess remain unchanged.

Fig. 4 shows the board 4 with the wiring 2 and the recess 16 in which a card module 20 is inserted. The card module 20 comprises a fully tested chip 9 which is connected to a fan-out wiring 11 arranged on the carrier 22. The carrier 22 has the size of the recess 16 and a thickness of 0.3 to 0.7 mm which corresponds to the depth of the recess. The fan-out wiring comprises at the edges of carrier 22 also lands 24 which are used to electrically connect the fan-out wiring of the card module to the wiring of the board. The fan-out wiring is adapted to the board wiring an corresponds with the removed fan-out wiring.

In Fig. 5 a complete board 4 is shown which comprises the card module 20 as depicted in Fig. 4 inserted and fixed, e.g. by glueing with an adhesive, in the recess 16. The fan-out wiring 10 of the card module 20 is connected via wire bonds 26 to the wiring 2 on the board 4 as shown in an enlarged detail view. The gap 28 between the card module 20 and the board 4 should be as small as possible to provide short wire bonds 26. The wire bonds 26 are also protected by a resin encapsulant (for purpose of clarity not shown). On the complete board with the fixed and placed card module inserted in the recess it is not recognizable whether a defect chip and fan-out have been at the same location before. Thus, under special circumstances a board might be constructed in this way with fully tested card modules.

## Claims

1. Method for replacing electronic components directly attached on a printed circuit board comprising
mechanically removing the electronic component (8) and the surrounding fan-out wiring area (10);
placing and fixing a card module (20), carrying an electronic component directly attached thereto, on the board (4) at the location of said removed electronic component and said fan-out wiring area such that the card module wiring matches with the board wiring (2); and
electrically connecting the wiring of said board with the wiring of said card module.

2. The method according to claim 1, wherein said mechanically removing provides a recess (16) in the board having the size of fan-out wiring area in which said card module is inserted.

3. The method according to claim 1 or 2, wherein said mechanically removing is accomplished by micro milling.

4. The method according to any one of the preceding claims, wherein said board wiring is wire bonded to the card module.

5. The method according to any one of the preceding claims 1 to 4, wherein said card module is fixed to the board by glueing.

6. Printed circuit board for carrying out the method according to any one of the preceding claims with at least one wiring layer on top of the board which comprises wiring lines (2) connecting the contact pads (12) of different electronic components (8) and at least one electronic component directly attached to the board (4), said board comprises contact means (6) which are arranged adjacent the fan-out wiring areas, on the wiring lines (2) leading to the contact pads of said directly attached component in a predetermined distance to said component.

7. The printed circuit board according to claim 6, wherein said contact means comprise contact lands.

8. The printed circuit board according to claim 6 or 7, wherein said contact means are arranged around the electronic component adjacent the fan-out wiring area.

9. Printed circuit board with at least one wiring layer on top of the board which comprises connection lines for connecting the different electronic components, said board comprises
contact means (6) in a predetermined distance to said component and adjacent to the fan-out wiring area (11) which are arranged on the wiring lines (2) leading to the contact pads (12) of at least one of said components, whereby the wiring lines are broken at the edge of a card module to provide a wiring free region;
said thin card module (20) carrying directly attached said at least one of said components (9) and the corresponding fan-out wiring area (11) and card contact means (24), said card module is directly fixed to said board such, that the fan-out wiring matches with the wiring on the board; and
connecting means (26) connecting said board contact means (6) to said card contact means.

10. The printed circuit board according to claim 9, wherein said thin card module is arranged in a recess (16).

11. The printed circuit board according to claim 9 or 10, wherein said contact means at least on the board are contact lands.

12. The printed circuit board according to any one of the preceding claims 9 to 11, wherein said connecting means are wire bonds.

## Patentansprüche

1. Verfahren zum Ersetzen von elektronischen Bauelementen, die direkt auf einer Leiterplatte befestigt sind, das folgendes umfaßt
mechanisches Entfernen des elektronischen Bauelements (8) und des umgebenden fächerartig ausgelegten Verdrahtungsbereiches (10);
Plazieren und Befestigen eines Kartenmoduls (20), das ein direkt darauf befestigtes elektronisches Bauelement trägt, auf der Leiterplatte (4) an der Stelle, an der sich das entfernte elektronische Bauelement und der fächerartig ausgelegte Verdrahtungsbereich befanden, so daß die Verdrahtung des Kartenmoduls mit der Verdrahtung (2) der Leiterplatte übereinstimmt; und
elektrisches Verbinden der Verdrahtung der Leiterplatte mit der Verdrahtung des Kartenmoduls.

2. Verfahren nach Anspruch 1, wobei das mechanische Entfernen eine Vertiefung (16) in der Leiterplatte mit der Größe des fächerartig ausgelegten Verdrahtungsbereichs bereitstellt, in die das Kartenmodul eingesetzt wird.

3. Verfahren nach Anspruch 1 oder 2, wobei das mechanische Entfernen durch Mikrofräsen erfolgt.

4. Verfahren nach einem beliebigen der vorausgehenden Ansprüche, wobei die Leiterplattenverdrahtung über Drahtbondverbindungen mit dem Kartenmodul verbunden ist.

5. Verfahren nach einem beliebigen der vorausgehenden Ansprüche 1 bis 4, wobei das Kartenmodul durch Aufkleben auf der Leiterplatte befestigt wird.

6. Leiterplatte zur Durchführung des Verfahrens nach einem beliebigen der vorausgehenden Ansprüche mit mindestens einer Verdrahtungsebene auf der Oberseite der Leiterplatte, die Verdrahtungsleitungen (2) umfaßt, welche die Kontaktstellen (12) von verschiedenen elektronischen Bauelementen (8) und mindestens ein elektronisches Bauelement, das direkt auf der Leiterplatte (4) befestigt ist, verbinden, wobei die Leiterplatte Kontaktmittel (6) einschließt, die neben den fächerartig ausgelegten Verdrahtungsbereichen auf den Verdrahtungsleitungen (2) angeordnet sind, welche zu den Kontaktstellen des direkt befestigten Bauelements in einem vorher festgelegten Abstand zu dem Bauelement führen.

7. Leiterplatte nach Anspruch 6, wobei die Kontaktmittel Kontaktstege einschließen.

8. Leiterplatte nach Anspruch 6 oder 7, wobei die Kontaktmittel um das elektronische Bauelement herum neben dem fächerartig ausgelegten Verdrahtungsbereich angeordnet sind.

9. Leiterplatte mit mindestens einer Verdrahtungsebene auf ihrer Oberseite, die Verbindungsleitungen für den Anschluß der verschiedenen elektronischen Bauelemente einschließt, wobei die Leiterplatte folgendes umfaßt
Kontaktmittel (6) in einem vorher festgelegten Abstand zu dem Bauelement und neben dem fächerartig ausgelegten Verdrahtungsbereich (11), die auf den Verdrahtungsleitungen (2) angeordnet sind, welche zu den Kontaktstellen (12) von mindestens einem der Bauelemente führen, wodurch die Verdrahtungsleitungen an der Kante eines Kartenmoduls unterbrochen werden, um einen verdrahtungsfreien Bereich zur Verfügung zu stellen;
das dünne Kartenmodul (20), das mindestens das eine der Bauelemente (9), das direkt darauf befestigt ist, den entsprechenden fächerartig ausgelegten Verdrahtungsbereich (11) und Kartenkontaktmittel (24) trägt, wobei das Kartenmodul direkt auf der Leiterplatte befestigt ist, so daß der gefächerte Verdrahtungsbereich mit der Verdrahtung auf der Leiterplatte übereinstimmt; und
Verbindungsmittel (26), welche die Leiterplatten-Kontaktmittel (6) mit den Kartenkontaktmitteln verbinden.

10. Leiterplatte nach Anspruch 9, wobei das dünne Kartenmodul in einer Vertiefung (16) angeordnet ist.

11. Leiterplatte nach Anspruch 9 oder 10, wobei zumindest die Kontaktmittel auf der Leiterplatte Kontaktstege sind.

12. Leiterplatte nach einem beliebigen der vorausgehenden Ansprüche 9 bis 11, wobei es sich bei den Verbindungsmitteln um Drahtbondverbindungen handelt.

## Revendications

1. Méthode de remplacement de composants électroniques, fixés directement sur une plaquette de circuit imprimé, comprenant :
l'enlèvement mécanique du composant électronique (8) et de l'aire de câblage de sortie (10) environnante;
la mise en place et la fixation d'un module de carte (10), portant un composant électronique lui étant directement fixé, sur la plaquette (4), à l'emplacement dudit composant électronique enlevé et de ladite aire de câblage de sortie, de manière que le câblage du module de carte s'adapte au câblage de plaquette (2); et
connexion électrique du câblage de ladite plaquette avec le câblage dudit module de carte.

2. La méthode selon la revendication 1, dans laquelle ledit enlèvement mécanique produit dans la plaquette une cavité (16), ayant la taille de l'aire de câblage de sortie dans laquelle ledit module de carte est insérée.

3. La méthode selon la revendication 1 ou 2, dans laquelle ledit enlèvement mécanique est accompli par un microfraisage.

4. La méthode selon la revendication 1 ou 2, dans laquelle ledit câblage de plaquette est lié par des connecteurs au module de carte.

5. La méthode selon l'une des revendications 1 à 4 précédentes, dans laquelle ledit module de carte est fixé à la plaquette par collage.

6. Plaquette de circuit imprimé pour mettre en oeuvre la méthode selon l'une quelconque des revendications précédentes, avec au moins une couche de câblage en partie supérieure de la plaquette, comprenant des lignes de câblage (2) assurant la liaison des plages de connexion par contact (12) de différents composants électroniques (8) et d'au moins un composant électronique directement fixé à la plaquette (4), ladite plaquette comprenant des moyens de contact (6) agencés adjacents aux aires de câblage de sortie sur les lignes de câblage (2), menant aux plages de connexion dudit composant directement fixé à une distance prédéterminée dudit composant.

7. La plaquette de circuit imprimé selon la revendication 6, dans laquelle lesdits moyens de contact comprennent des zones de contact.

8. La plaquette de circuit imprimé selon la revendication 6 ou 7, dans laquelle lesdits moyens de contact sont agencés autour du composant électronique adjacent à ladite aire de câblage de sortie.

9. Plaquette de circuit imprimé comportant au moins une couche de câblage en partie supérieure de la plaquette, comprenant des lignes de connexion pour assurer la liaison des différents composants électroniques, ladite plaquette comprenant :
des moyens de contact (6) placés à une distance prédéterminée vis-à-vis dudit composant et adjacents à ladite aire de câblage de sortie (11) agencés sur les lignes de câblage (2) menant aux plages de connexion par contact (12) d'au moins l'un desdits composés, de manière que les lignes de câblage soient rompues au bord d'un module de carte pour constituer une zone exempte de câblage;
ledit module de carte (20) mince portant, lui étant directement fixés, ledit au moins un desdits composants (9) et l'aire de câblage de sortie (11) correspondante et des moyens de contact de carte (24), ledit module de carte étant directement fixé à ladite plaquette, de manière que le câblage de sortie s'adapte avec le câblage réalisé sur la plaquette; et
du moyen de connexion (26) assurant la connexion desdits moyens de contact de plaquette (6) audit moyen de contact de carte.

10. La plaquette à circuit imprimé selon la revendication 9, dans laquelle ledit module de carte mince est agencé dans une cavité (16.

11. La plaquette à circuit imprimé selon la revendication 9 ou 10, dans laquelle ledit moyen de contact constitue, au moins sur la plaquette, des zones de contact.

12. La plaquette à circuit imprimé selon l'une quelconque des revendications 9 à 11 précédentes, dans laquelle lesdits moyens de connexion sont des liaisons par connecteurs.
